Europäisches Patentamt

European Patent Office

Office européen des brevets

Publication number: **0 297 799**
**A1**

(12) **EUROPEAN PATENT APPLICATION**

(21) Application number: 88305810.9

(22) Date of filing: 24.06.88

(51) Int. Cl.⁴ **H01L 31/18 , H01L 31/02 , H01L 21/368**

(30) Priority: 26.06.87 GB 8715082

(43) Date of publication of application:
04.01.89 Bulletin 89/01

(84) Designated Contracting States:
**BE DE ES FR GB GR IT NL**

(71) Applicant: **PRUTEC LIMITED**
**142 Holborn Bars**
**London EC1N 2NH(GB)**

(72) Inventor: **Cumberbatch, Toby John**
**33, Cavendish Road**
**Cambridge CB1 3AE(GB)**

(74) Representative: **Messulam, Alec Moses**
**A. Messulam & Co. 24 Broadway**
**Leigh on Sea Essex SS9 1BN(GB)**

(54) Manufacture of Solar Cells.

(57) A precursor solution is described for use in the formation in a solar cell of a thin film of a ternary or quaternary compound containing copper, at least one group III element selected from aluminium, gallium and indium and a group VI element selected from sulphur, selenium and tellurium. The solution being formed by dissolving a dry cuprous halide in an organic solvent such as acetonitrile capable of solvating the cuprous ions to form a complex ion in which the cuprous ions are joined to organic ligands, and adding to the organic solution an aqueous solution of salts containing the group III element(s).

The precursor solution can be used either in spray pyrolysis deposition techniques or to form a colloid which is deposited electrophoretically.

EP 0 297 799 A1

# Manufacture of Solar Cells

The present invention relates to the manufacture of thin film photovoltaic cells.

Copper based ternary and quaternary chalcopyrites are being used in thin film photovoltaic cells and some papers on this subject have been published in the technical journals. Copper indium diselenide ($CuInSe_2$), with a bandgap of 1.04eV, may be used in a single heterojunction device with, for example, cadmium sulphide (CdS) due to its high absorption coefficient ($>10^7 m^{-1}$) over a large part of the solar spectrum and good lattice match to CdS. Copper indium disulphide possesses a bandgap ($E_g = 1.55eV$) with a better match to the solar spectrum and has been used to produce a liquid junction solar cell with an efficiency of 10%. However, the properties of this material are difficult to control and for this reason attempts are being made to develop quaternaries such as $CuIn_xGa_{1-x}Se_2$ because the stoichiometry of the material can be adjusted to produce a bandgap with an optimum match to the terrestrial solar spectrum ($E_g = 1.45eV$).

The present invention is concerned with the synthesis and deposition of films of $CuInS_2$, $CuInSe_2$, $CuGaSe_2$ and quaternary compounds such as $CuIn_{1-x}Ga_xSe_2$.

Prior art attempts at forming such films by spraying a precursor solution onto a hot surface have suffered from problems associated with the instability of the precursor solution. For example, in one known technique the precursor solution is prepared by dissolving cupric chloride, indium chloride and dimethyl selenourea (DMSU) in water. This solution is unstable because the copper attacks the selenium compound causing undesired precipitation of elemental selenium.

If hydrochloric acid is added, as has been proposed, this reduces the rate of precipitation of selenium but while the solution is now more stable, it is still not of practical use in the formation of solar cells as it may etch the cadmium sulphide layer. Furthermore, only small copper ion concentrations can be stably achieved, resulting in prolonged deposition periods for growth of the layer.

As it is desired to form a layer containing copper in its monovalent (cuprous) state, it is preferred to start with the copper ions in this oxidation state. However, the cuprous ion is normally unstable in pure aqueous solutions and its solubility is low. In this case, the addition of acid forms complexes which increase the stability and solubility, but again a risk occurs of etching the underlying cadmium sulphide layer.

The object of the present invention is to provide a precursor solution containing copper ions in the monovalent oxidation state and ions of a group III metal, which solution contains a relatively high concentration of copper ions and is stable for storage over prolonged periods.

According to a first aspect of the present invention, there is provided a precursor solution for use in the formation in a solar cell of a thin film of a ternary or quaternary compound containing copper, at least one group III element selected from aluminium, gallium and indium and a group VI element selected from sulphur, selenium and tellurium, the solution being formed by dissolving a dry cuprous halide in an organic dipolar aprotic solvent capable of solvating the cuprous ions to form a complex ion in which the cuprous ions are joined to organic ligands, and adding to the organic solution an aqueous solution of salts containing the group III elements.

The organic solvent is preferably acetonitrile and the cuprous halide salt is preferably cuprous iodide.

The group III salts are preferably nitrates of gallium and/or indium.

The effect of forming an organic complex of the cuprous ions and the acetonitrile ligands is to prevent oxidation of the cuprous ions into cupric ions by reacting amongst themselves ($2Cu^+ > Cu^{2+} + Cu$) in the presence of water. It is in this respect advantageous to minimise the quantity of dissolved oxygen in the water and to this end the solution should be stored in an inert atmosphere (nitrogen) and nitrogen should be bubbled through the solution to liberate dissolved oxygen.

To prepare a precursor solution for forming a thin film by spray pyrolysis, selenium may be added to the solution by adding a selenium compound, preferably DMSU in solid form, directly to the solution.

According to a second aspect of the present invention, there is provided a method of forming a thin film of a ternary or quaternary compound containing copper, at least one group III element selected from aluminium, gallium and indium and a group VI element selected from sulphur, selenium and tellurium, the method comprising the steps of forming a solution containing cuprous ions by dissolving a dry cuprous halide in an organic dipolar aprotic solvent capable of solvating the cuprous ions to form a complex ion in which the cuprous ions are joined to organic ligands, adding to the organic solution an aqueous solution of salts containing the group III elements and reacting the solution with a compound containing the group VI element to form a colloidal suspension of the material to be deposited, and forming a thin film by electrophoretic deposition from the colloidal suspension onto a substrate.

In the case of a solar cell, the powder-like deposit does not have the requisite crystal size and to form a better photovoltaic junction with the underlying cadmium sulphide layer, it is advantageous to recrystallise the deposit by the application of heat.

The heat required to cause such recrystallisation may damage the substrate but many possibilities present themselves to confine the energy to the deposited film. For example, the deposit can be heated by a laser, tungsten halogen lights or possibly microwave radiation.

It is already known from scientific publications that a scanned $CO_2$ laser beam can be used to transform an electrophoretically deposited CdS layer into a polycrystalline thin film and this is accompanied by a dramatic increase in the luminescence efficiency. The lower melting point of these materials and reduced vapour pressure of selenium when compared to sulphur suggests that recrystallisation via a rapid thermal annealing process is possible without loss of stoichiometry.

The invention will now be described further by reference to specific examples.

A solution for spray pyrolysis of a $CuInSe_2$ is prepared by dissolving cuprous iodide, previously dried by heating in an oven, in acetonitrile, previously dried by means of a molecular sieve, in an amount of 3.88 g/l to give a 0.02 molar solution. Hydrated indium nitrate is dissolved in cold water to form a 0.02 molar solution, allowance being made in this case for the hydration level of the salt in determining the weight of the salt added to a given volume of water. The organic solution of cuprous iodide is next mixed with the aqueous solution of indium nitrate and to this a quantity of DMSU in solid form is added in the appropriate molar ratio. The concentration of indium, copper and selenium can be varied to yield films with varying electrical properties, and the optimum ratios can be determined empirically, in practice.

To form a photovoltaic junction, the precursor solution as prepared above is sprayed using a spray pyrolysis system as described in EP-A-O 266 142. This apparatus uses airless electrostatic atomisation of the precursor solution and the droplets on the surface of the substrate are heated from above and below by radiant heaters to cause the compounds in the solution to react with one another and to drive off the solvents, leaving a deposit of $CuInSe_2$. The thin film is grown epitaxially on a thin film of cadmium sulphide, or cadmium zinc sulphide, with which the ternary compound forms a rectifying junction. The temperature of the surface is maintained between 200°C and 450°C, the optimum temperature being again determined empirically.

For the formation of a thin film by electrophoretic deposition from a colloidal suspension of the ternary or quaternary compound, equal volumes of an aqueous solution of the required group III metal nitrate(s) is added to an equimolar acetonitrile solution of cuprous iodide, to give a final molarity of 0.01 molar, or less. This solution is then thoroughly stirred and deoxygenated prior to the addition of the respective group VI hydride ($H_2Se$ or $H_2S$) which results in the apparently instantaneous formation of a stable colloid of the appropriate ternary or quaternary compound. The introduction of the hydride is limited in order to avoid excessive selenide or sulphide ion concentrations.

Experimental evidence suggests that pre-association takes place between the group III metal(s) ions and the cuprous cations after the aqueous and acetonitrile solutions are mixed. Measurement of ligand exchange rates, indicates that, in the absence of such pre-association, the formation of a copper binary would be favoured during the addition of a group VI hydride.

The stability of the colloids is related to the type of group III metals present with indium appearing to increase the interval prior to natural flocculation. The shelf life of these colloids from one day for $Cu_xSe$ to approximately five days for $CuIn_{1-x}Ga_xSe_2$.

Examination of the solid from a freshly prepared $CuInSe_2$ colloid in the TEM (transmission electron microscope) shows that the particle size is very uniform, with an average diameter of approximately 3.5nm. The electron diffraction powder patterns, and at higher magnifications, the presence of lattice fringes in the particles indicates their crystallinity and homogeneous structure. Samples suitable for x-ray diffraction measurements were prepared by flocculating the colloids through the addition of a suitable electrolyte and subsequently separating the solid by centrifugation. The precipitate was then thoroughly washed with deionised water to remove all traces of precursor salts and the added electrolyte prior to dispersion in deionised water. The powder was finally mixed with a water soluble glue (Seccotine), and applied to a glass cover slide.

The X-ray diffractometer powder patterns from $CuInSe_2$, $CuGaSe_2$, and $CuIn_{1-x}Ga_xSe_2$ clearly reveal the three principal reflections expected from these materials with a tetragonal structure in the absence of any preferred orientation. The positions and amplitudes of the peaks compare favourably with published data confirming that the ternary or quaternary compounds are the principal components of the precipitate. It also clear that the reflections from the $CuIn_{1-x}Ga_xSe_2$ lie between those of the related ternaries as would be expected.

The optical absorbance of the colloidal suspensions was measured, and compared with that from a binary suspension, to confirm that ternary and quaternary semiconductors had been produced. A small volume of each colloid was placed in a cuvette and diluted with the original mixed solvent to adjust the maximum transmission to about 50%. The data clearly revealed four distinct semiconductor materials although the size of the particles leads to an ill-defined absorption edge and what would appear to be a blue shift in the apparent size of the bandgap.

The optical absorbances for two of the colloids were measured after the particles had been allowed to age for two days in the original solution and, in the case of $CuIn_{1-x}Ga_xSe_2$, a red shift in the absorption edge is evident as is a sharpening of the edge itself. The corresponding data for $CuInSe_2$ indicate a smaller effect.

A qualitative assessment of the impurity content of the colloidal particles was undertaken using Laser Mass Spectrometry (LAMS) in which a microvolume of the material is vaporised by an intense pulse of laser radiation and subsequently introduced into a mass analyser. The spectra from $CuInS_2$ and $CuInSe_2$ particles contained only traces of the alkali metals, probably introduced by handling and to which the instrument is particularly sensitive ($=10^{-3}$ppm), in addition to the three constituent elements. Furthermore the spectra from a single crystal of $CuInSe_2$ compared very favourably with that obtained from the colloidal particles.

The results outlined above refer to deposits formed from colloidal suspensions and the results obtained for deposits produced by spray pyrolysis are also promising. The X-ray diffraction pattern of a $CuInSe_2$ indicated the presence of a single ternary compound with a preferred orientation perpendicular to the substrate. These observations were corroborated by measurements of optical absorption.

## Claims

1. A precursor solution for use in the formation in a solar cell of a thin film of a ternary or quaternary compound containing copper, at least one group III element selected from aluminium, gallium and indium and a group VI element selected from sulphur, selenium and tellurium, the solution being formed by dissolving a dry cuprous halide in an organic dipolar aprotic solvent capable of solvating the cuprous ions to form a complex ion in which the cuprous ions are joined to organic ligands, and adding to the organic solution an aqueous solution of salts containing the group III element(s).

2. A solution as claimed in claim 1, wherein the organic solvent is acetonitrile.

3. A solution as claimed in claim 1 or 2, wherein the cuprous halide salt is cuprous iodide.

4. A solution as claimed in any preceding claim, wherein the group III salts are nitrates of gallium and/or indium.

5. A solution as claimed in any preceding claim, wherein the aqueous solution of group III salts is deoxygenated prior to being mixed with the acetonitrile solution.

6. A solution as claimed in any preceding claim, for forming a thin film by spray pyrolysis, wherein a selenium compound is added to the solution.

7. A method of forming a thin film of a ternary or quaternary compound containing copper, at least one group III element selected from aluminium, gallium and indium and a group VI element selected from sulphur, selenium and tellurium, the method comprising the steps of forming a solution containing cuprous ions by dissolving a dry cuprous halide in an organic dipolar aprotic solvent capable of solvating the cuprous ions to form a complex ion in which the cuprous ions are joined to organic ligands, adding to the organic solution an aqueous solution of salts containing the group III elements and reacting the solution with a compound containing the group VI element to form a colloidal suspension of the material to be deposited, and forming a thin film by electrophoretic deposition from the colloidal suspension onto a substrate.

8. A method as claimed in claim 7, wherein the deposit is recrystallised by the application of heat.

9. A method as claimed in claim 8, wherein heat is applied by exposing the deposit to a laser.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | PROCEEDINGS OF THE FIRST EC PHOTOVOLTAIC SOLAR ENERGY CONFERENCE, Luxemburg, 27th-30th September 1977, pages 601-607, D. Reidel Publishing Co., Dordrecht, NL; J. VEDEL et al.: "Spray preparation of cuprous sulfide layers" * Whole article * | 1,6 | H 01 L 31/18 H 01 L 31/02 H 01 L 21/368 |
| A | IDEM | 2 | |
| Y | SOLAR CELLS, vol. 14, no. 2, May 1985, pages 123-131, Elsevier Sequoia, Lausanne, CH; P. RAJA RAM et al.: "Totally sprayed CuInSe2/Cd(Zn)S and CuInS2/Cd(Zn)S solar" * Pages 123,124 * | 1,6 | |
| A | THE CONFERENCE RECORD OF THE SEVENTEENTH IEEE PHOTOVOLTAIC SPECIALISTS CONFERENCE, Kissimmee, Florida, 1st-4th May 1984, pages 786-791, IEEE, New York, US; D. CAHEN et al.: "CuInSe2-based photoelectrochemical cells: their use in characterization of thin CuInSe2 films, and as photovoltaic cells per se" * Pages 787,788,789; page 790, column 1, lines 1-22; figures 6,7 * | 1,2 | TECHNICAL FIELDS SEARCHED (Int. Cl.4) H 01 L |
| D,A | EP-A-0 266 142 (PRUTEC LTD) * Whole document * -/- | 1-3,6 | |

The present search report has been drawn up for all claims

| Place of search | Date of completion of the search | Examiner |
|---|---|---|
| THE HAGUE | 13-10-1988 | VISENTIN A. |

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | FR-A-2 352 078 (IMPERIAL CHEMICAL INDUSTRIES LTD) <br> * Page 14, line 20 - page 16, line 26; claims 1-3,7-10 * | 1,2,7,8 | |
| A | JAPANESE JOURNAL OF APPLIED PHYSICS, vol. 23, no. 8, August 1984, pages 965-969, part 1, Tokyo, JP; H. ONNAGAWA et al.: "Optical and electrical properties of CuInS2 thin films by spray pyrolysis" | | |
| A | THIN SOLID FILMS, vol. 121, no. 2, November 1984, pages 85-94, Elsevier Sequoia, Lausanne, CH; P.C. PANDE et al.: "The properties of electrophoretically deposited layers of CdS" | | |

TECHNICAL FIELDS SEARCHED (Int. Cl.4)

The present search report has been drawn up for all claims

| Place of search | Date of completion of the search | Examiner |
|---|---|---|
| THE HAGUE | 13-10-1988 | VISENTIN A. |

EPO FORM 1503 03.82 (P0401)